# EUROPEAN PATENT SPECIFICATION

(11) **EP 1 619 266 B1**
(45) Date of publication and mention of the grant of the patent: **12.05.2010**
(21) Application number: 04717827.2
(22) Date of filing: 05.03.2004
(51) Int. Cl.: C23C 16/04, C23C 16/505, C23C 16/511, H01J 37/32

(54) **METHOD AND APPARATUS FOR CHEMICAL PLASMA PROCESSING OF PLASTIC CONTAINERS**
VERFAHREN UND VORRICHTUNG ZUR CHEMISCHEN PLASMAVERARBEITUNG VON KUNSTSTOFFBEHÄLTERN
PROCEDE ET APPAREIL PERMETTANT DE TRAITER DES RECIPIENTS EN PLASTIQUE PAR PLASMA CHIMIQUE

(30) Priority: 12.03.2003 JP 2003066912
(43) Date of publication of application: 25.01.2006
(73) Proprietor: Toyo Seikan Kaisha, Ltd., Tokyo 100-0011 (JP)
(72) Inventor: KOBAYASHI, Akira, c/o Toyo Seikan Group Corporate, Yokohama-shi, Kanagawa 2400062 (JP); YAMADA, Koji, c/o Toyo Seikan Group Corporate, Yokohama-shi, Kanagawa 2400062 (JP); AIHARA, Takeshi, c/o Toyo Seikan Group Corporate, Yokohama-shi, Kanagawa 2400062 (JP); KURASHIMA, Hideo, c/o Toyo Seikan Group Corporate, Yokohama-shi, Kanagawa 2400062 (JP)
(74) Representative: Manley, Nicholas Michael
(86) International application number: PCT/JP2004/002836
(87) International publication number: WO 2004/081253

(56) References cited:
- WO-A-97/44503
- WO-A-99/17333
- JP-A- 6 184 628
- JP-A- 06 313 671
- JP-A- 10 330 945
- JP-A- 2001 518 685
- JP-A- 2002 017 071
- JP-A- 2002 051 586
- WEICHART J ET AL: "BESCHICHTUNG VON DREIDIMENSIONALEN SUBSTRATEN MIT EINEM MAGNETFELDUNTERSTUETZTEN MIKROWELLEN-PLASMA BEI RAUMTEMPERATUR" VAKUUM IN DER PRAXIS, WEINHEIM, DE, vol. 3, no. 1, 1 February 1991 (1991-02-01), pages 22-26, XP002067698 ISSN: 0934-9758

## Description

### (Technical Field)

The present invention relates to a method of treating plastic containers with a chemical plasma relying upon a glow discharge by using microwaves or high frequency waves, and to an apparatus therefor.

### (Background Art)

The chemical vapor deposition (CVD) is a technology for precipitating, like a film, a reaction product on the surface of a base body by the vapor-phase growth in a high-temperature atmosphere by using a starting gas which does not undergo the reaction at normal temperature, has been widely employed in the production of semiconductors and in reforming the surfaces of metals, glasses and ceramics, and has nowadays been employed even for reforming the surfaces of plastic containers such as plastic bottles and, particularly, for improving gas shut-off property.

The plasma CVD is for growing a thin film by utilizing a plasma and basically comprises a process in which a gas containing a starting gas is discharged by using electric energy under a reduced pressure so as to be decomposed, and the substance that is formed is deposited on a substrate through a chemical reaction in the vapor phase or on the substrate.

The plasma state is realized by a glow discharge. Depending upon the systems of glow discharge, there have been known a method which utilizes a DC glow discharge, a method which utilizes a high-frequency glow discharge and a method which utilizes a microwave glow discharge.

A method of forming a film on the inner surface of a plastic container by the CVD has been known already as represented by a method of treating the inner surface of a plastic bottle which comprises a container body of substantially a cylindrical shape, a bottom portion which is one surface of the container body, a shoulder portion and a neck portion with a narrow opening portion in the other surface of the container body relying upon a plasma-reinforced process. This process comprises the steps of simultaneously deaerating the interior of the bottle and the chamber on the outside of the bottle, igniting a plasma in the bottle and maintaining it, flowing a treating gas through the bottle for a predetermined treating time, and ventilating the interior and the exterior of the bottle simultaneously after the passage of a predetermined treating time. To execute the step of the treatment, the bottle is located in the confinement of the microwaves of substantially a cylindrical shape in concentric therewith, the plasma is ignited and maintained in the bottle, the microwaves are connected from one surface of the confinement of the microwaves up to the other surface to where the bottom of the bottle is facing, so that the confinement of the microwaves is excited by the resonance of TM mode (see WO99/17334).

### (Disclosure of the Invention)

According to the method of treatment with a plasma disclosed in the above prior art, the plastic bottle is usually held in a plasma-treating chamber supplied with microwaves, the interior and exterior of the bottle are evaluated down to predetermined pressures, a gas-feed pipe is inserted through the neck of the bottle to supply a reactive starting gas into the bottle, and a glow discharge is generated therein to form a plasma-treated film (CVD film) on the inner surface of the bottle. After the film is formed, the interior and exterior of the bottle are returned back to the atmospheric pressure, and the bottle forming the film is taken out. However, if the plasma treatment is conducted relying upon the above method by supplying large energy of microwave or for extended periods of time, there occurs a problem in that the plastic bottle contracts or deforms as it is treated with the plasma. In particular, the peripheral edge portions of the bottom of the bottle are deformed to a large extent.

It is, therefore, an object of the present invention to provide a method of treatment with a plasma which effectively suppresses the deformation of a plastic container and, particularly, the deformation due to heat generated in the treatment with plasma based on a glow discharge by using microwaves or high frequency waves, which is capable of forming a film by CVD on the surface and, particularly, on the inner surface of the plastic container consecutively for extended periods of time using stronger microwaves or high-frequency energy, greatly enhancing the quality of the deposited film and productivity, and an apparatus therefor. The invention further provides a method of treating plastic containers with a plasma, which is capable of effecting the treatment with a plasma without causing thermal deformation even when the plastic container is made of a material which is thermally weak or even when the plastic container is subject to be deformed due to its thickness and shape.

According to the present invention, there is provided a method of treating plastic containers with a chemical plasma by forming a film by CVD on the inside surface of the plastic containers in a plasma-treating chamber, wherein said plastic container is cooled at the time of forming the film by CVD on the plastic container by generating a glow discharge by feeding a gas for plasma treatment into the plasma-treating chamber, the gas for plasma treatment is fed into the plastic container to generate the glow discharge on the inner surface of the plastic container in a state of a reduced pressure, the cooling gas is blown to the outer surface of the plastic container while maintaining the exterior of the plastic container in a state of a reduced pressure where no glow discharge takes place, and the plastic container is held upside down in the plasma-treating chamber and, in this state, the glow discharge is generated and the cooling gas is blown to the outer surface of the container.

According to the present invention, there is further provided an apparatus for treating plastic containers with a chemical plasma by forming a film by CVD on the inside surface of the plastic container in a plasma-treating chamber, comprising means for holding the container upside down in the plasma-treating chamber, a gas-feeding pipe for feeding a gas for plasma treatment into the plastic container through a first exhaust portion, a microwave or high frequency wave feeding portion for generating a glow discharge in the plastic container in the plasma-treating chamber, a second exhaust portion for maintaining the exterior of the plastic container in a state of a reduced pressure where no glow discharge takes place, and a cooling gas-feeding portion for blowing a cooling gas onto the outer surface of the plastic container, so that the film is formed by CVD on the inner surface of the plastic container.

According to the present invention, it is desired that:
1. The compressed air or nitrogen is used as the cooling gas;
2. The glow discharge is generated by feeding microwaves or high-frequency waves;
3. The cooling gas-feeding portion is provided in the ceiling wall and/or the cylindrical side wall of the plasma-treating chamber; and
4. The cooling gas-feeding portion is of a squeezed shape having a diameter becoming smaller toward the inside of the plasma-treating chamber.

According to the present invention, the plastic container is treated with the plasma while being cooled effectively suppressing the plastic container such as the plastic bottle from being deformed and contracted. Even when the treatment with the plasma is repeated consecutively, the plastic bottle is effectively suppressed from being deformed and contracted, and the productivity is greatly enhanced.

In forming the film by CVD on the inner surface of the plastic container, in particular, the treatment with the plasma may be conducted while blowing the cooling gas onto the portions that is subject to be thermally deformed on the outer surface of the plastic container such as the plastic bottle that is to be treated with the plasma.

### (Brief Description of the Drawings)

Fig. 1 is a view illustrating the structure of an apparatus for putting a method of treatment with a plasma of the present invention into practice;
Fig. 2 is a diagram plotting a relationship between the number of times of the plasma treatment (number of times of producing the bottles) relying upon the ordinary microwave glow discharge and the temperature of a metallic gas-feeding pipe (nozzle temperature);
Fig. 3 is a diagram plotting a relationship between the change in the volume of the bottle when the plasma treatment is repeated in the same manner as in Fig. 2 and the temperature of the gas-feeding pipe (nozzle temperature) ; and
Fig. 4 is a diagram plotting a relationship between the temperature of the outer surface of the bottom portion of the bottle immediately after the plasma treatment and the amount of contraction of the bottom of the bottle depending upon when the cooling gas is blown and not blown.

### (Best Mode for Carrying Out the Invention)

### (Plasma-treating apparatus)

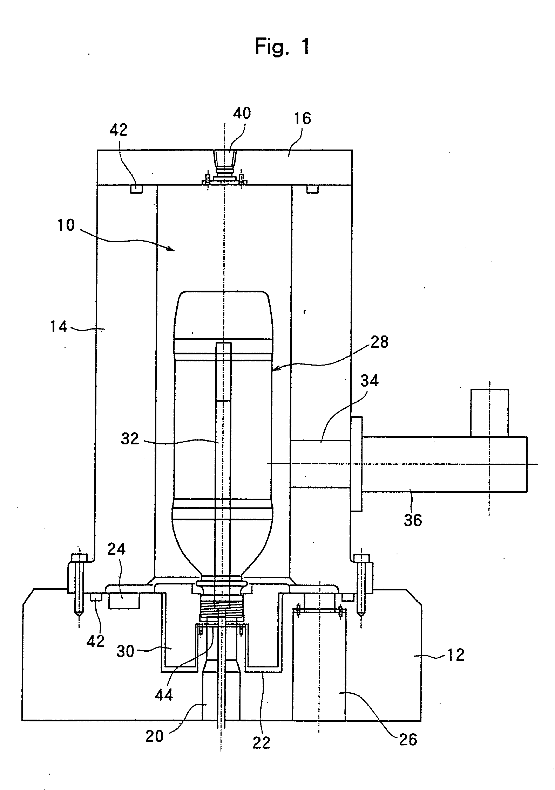

Fig. 1 illustrates the structure of the plasma-treating apparatus used for favorably treating a plastic container and, particularly, the inner surface of the plastic container with a plasma, wherein a plasma-treating chamber which as a whole is designated at 10 is constituted by an annular base plate 12, a cylindrical side wall 14, and a ceiling wall 16 closing the upper part of the cylindrical side wall 14.

A first exhaust portion 20 is formed in the central part of the annular base plate 12, an annular recessed portion 22 is formed in the upper surface of the base plate 12 so as to surround the first exhaust portion 20, and an annular groove 24 is formed surrounding the annular recessed portion 22, the annular groove 24 being communicated with the second exhaust portion 26.

In the annular recessed portion 22, there is contained a bottle holder 30 for holding a bottle 28 upside down. As will be obvious from Fig. 1, the neck portion of the bottle 28 which is held upside down is fitted onto the bottle holder 30. The neck portion of the bottle 28 held by the holder is communicated with the first exhaust portion 20, and a gas-feeding pipe 32 is inserted in the bottle 28 from the first exhaust portion 20 through the neck portion of the bottle 28.

The cylindrical side wall 14 is provided with a microwave -feeding portion 34 which is connected to a microwave transmission member 36 such as a waveguide or a coaxial cable. That is, microwaves are introduced into the plasma-treating chamber 10 from a predetermined microwave oscillator through the microwave transmission member 36.

The ceiling wall 16 is provided with a cooling gas-feeding portion 40 from which the cooling as is blown in a concentrated manner onto the bottom of the bottle 28 that is held upside down in the plasma-treating chamber 10. The cooling gas-feeding portion 40 or the cooling gas-feeding pipe connected thereto is normally closed by an electromagnetic valve.

The cooling gas-feeding portion 40 is provided in the ceiling wall 16 and/or in the cylindrical side wall 14 depending upon the shape of the plastic container that is to be treated with a chemical plasma.

In order to maintain the plasma-treating chamber 10 hermetically sealed, O-rings 42 are provided in the interface between the base plate 12 and the cylindrical side wall 14 and in the interface between the cylindrical side wall 14 and the ceiling wall 16. Further, the bottle holder 30, too, is provided with the O-ring 42 for shielding the interior of the bottle 28 from the exterior thereof.

The first exhaust portion 20 and the second exhaust portion 26 formed in the base plate 12 are provided with shields 44 for confining the microwaves.

The base plate 12, cylindrical side wall 14 and ceiling wall 16 are all made of metals for confining the microwaves.

### (Plasma-treating method)

To execute the plasma treatment, first, the bottle holder 30 holding the bottle 28 upside down is mounted on the annular recessed portion 22 in the base plate 12, and the base plate 12 in this state is ascended by using a suitable ascending/descending device so as to be intimately attached to the cylindrical side wall 14 thereby to constitute the plasma-treating chamber 10 which is hermetically sealed and contains the bottle 28 upside down as shown in Fig. 1.

Next, the gas-feeding pipe 32 is inserted in the bottle 28 through the first exhaust portion 20, a vacuum pump is driven to evaluate through the first exhaust portion 20, and the interior of the bottle 28 is maintained in a vacuum state. At this moment, to prevent the bottle 28 from being deformed by the external pressure, the pressure in the plasma-treating chamber 10 outside of the bottle 28 is reduced by the vacuum pump through the second exhaust portion 26.

The degree of reducing the pressure in the bottle 28 is such that the treating gas is introduced therein from the gas-feeding pipe 32 and the microwaves are introduced therein to generate a glow discharge, and is in a range of, for example, 2 to 500 Pa and, particularly desirably, 5 to 200 Pa. On the other hand, the degree of reducing the pressure in the plasma-treating chamber 10 outside the bottle 28 is such that the glow discharge does not take place despite the microwaves are introduced therein, and is in a range of, for example, 500 to 50000 Pa preventing the bottle 28 from being deformed by the external pressure.

After the pressure has been reduced, the treating gas is introduced into the bottle 28 from the gas-feeding pipe 32, and the microwaves are introduced into the plasma-treating chamber 10 through the microwave transmission member 36 to generate a plasma by glow discharge. The electronic temperature in the plasma is several tens of thousand degrees K which is about hundreds of times as high as the temperature of gaseous particles which is several hundred degrees K, establishing a thermally non-equilibrium state enabling the plasma treatment to be effectively conducted even for the plastic base bodies of low temperatures.

In the present invention, the cooling gas is introduced from the cooling gas-feeding portion 40 provided in the ceiling wall 16 while introducing the treating gas and the microwaves, the plasma treatment is conducted by a microwave glow discharge while blowing the cooling gas in a concentrated manner onto the bottom of the bottle 28 that is being treated, and a film of a composition dependent upon the kind of the treating gas that is fed is formed by CVD on the inner surface of the bottle 28.

In introducing the cooling gas, it is necessary that the pressure on the outside of the bottle 28 in the treating chamber 10 is maintained reduced to a degree that does not permit the glow discharge to occur, i.e., the pressure is maintained reduced to a degree that the bottle 28 is not deformed despite the pressure is increased as a result of introducing the cooling gas. For this purpose, the cooling gas may be fed while continuing the evacuation through the second exhaust portion 26.

After the plasma treatment is effected as desired, introduction of the treating gas and introduction of the microwaves are discontinued, the cooling gas is continuously introduced from the cooling gas-feeding portion 40, the exterior of the bottle 28 is returned back to normal pressure, the atmosphere is introduced even from the side of the first exhaust portion 20 to simultaneously return the pressure to normal even in the bottle 28. Thereafter, the bottle 28 treated with the plasma is taken out from the plasma-treating chamber 10.

The time for the plasma treatment may vary defending upon the inner surface area of the bottle to be treated, thickness of the thin film to be formed and the kind of the treating gas, and cannot be definitely determined. In the case of a 2-liter plastic bottle, however, the plasma-treating time must not be shorter than one second per a bottle from the standpoint of stability in the plasma treatment and may be in the order of minutes, if necessary, though it is desired to shorten the time from the standpoint of cost.

As described already, the treatment is conducted while blowing the cooling gas onto the bottom portion of the bottle 28 to effectively suppress the bottle 28 from being deformed and contracted. Even when the plasma treatment is consecutively repeated, there is obtained a favorably treated bottle without deformation or contraction. For example, even when the next bottle is readily plasma-treated and even when such a plasma treatment is consecutively repeated, the bottle is effectively suppressed from being deformed and contracted contributing to greatly enhancing the productivity.

### (Gas-feeding pipe 32)

In the present invention, the gas-feeding pipe 32 for feeding the treating gas into the bottle 28 may be made of any material provided it is capable of uniformly and stably feeding the treating gas but is, particularly desirably, made of a metal. That is, a metallic feeding pipe also works as an antenna to emit electrons so as to generate plasma relying upon a stable glow discharge within a short period of time, and enables the treating time to be shortened. Further, the metallic feeding pipe works as an antenna for the microwaves generating heat by itself to elevate the temperature of the bottle 28 and causing the bottle to be deformed and contracted. According to the present invention, however, the plasma treatment is effected while blowing the cooling gas onto the bottom portion of the bottle 28 effectively preventing the bottle from being deformed and contracted, i.e., exhibiting the advantage of the metallic feeding pipe to a maximum degree, which is one of the greatest advantages of the invention.

It is further desired that the gas-feeding pipe 32 is a porous pipe from the standpoint of uniformly feeding the treating gas onto the inner surface of the bottle and further has a size of opening specified under, for example, nominal filtering precision in a range of 1 to 300 µm. Here, the nominal filtering precision is one of the characteristic values employed when a porous material is used as a filter. For instance, the nominal filtering precision 130 µm stands for that the porous material that is used as a filter is capable of trapping foreign matter having the above particle size.

In the present invention, the gas-feeding pipe 32 is most desirably made of a metallic porous pipe, and is made of a porous metal such as of bronze particles or stainless steel particles.

### (Plastic container 28 to be treated)

In the present invention, the plastic containers on which the film is to be formed by plasma treatment may be the containers of various shapes such as plastic cups, in addition to the plastic bottle shown in Fig. 1. However, a plastic bottle is particularly desired.

As the plastic material, there can be used known thermoplastic resins, for example, polyolefins such as low-density polyethylene, high-density polyethylene, polypropylene, poly 1-butene, poly 4-methyl-1-pentene or random or block copolymers of α-olefins, such as ethylene, propylene, 1-butene and 4-methyl-1-pentene; ethylene/vinyl compound copolymers such as ethylene/vinyl acetate copolymer, ethylene/vinyl alcohol copolymer and ethylene/vinyl chloride copolymer; styrene resins such as polystyrene, acrylonitrile/styrene copolymer, ABS, α-methylstyrene/styrene copolymer; polyvinyl compounds such as polyvinyl chloride, polyvinylidene chloride, vinyl chloride/vinylidene chloride copolymer, methyl polyacrylate, and methyl polymethacrylate; polyamides such as nylon 6, nylon 6-6, nylon 6-10, nylon 11 and nylon 12; thermoplastic polyesters such as polyethylene terephthalate, polybutylene terephthalate and polyethylene naphthalate; biodegradable resins such as polycarbonate, polyphenylene oxide and polylactic acid, or mixtures thereof.

The present invention is best suited for treating, particularly, the bottles made of a thermoplastic polyester such as polyethylene terephthalate.

### (Treating gas)

As the treating gas to be fed from the gas feeding pipe 32, there can be used various gases that have been known depending upon the object of treatment with the plasma.

In order to reform the surface of the plastic bottle, for example, there can be used a carbonic acid gas to introduce a crosslinking structure into the surface of the plastic base body or there can be used a fluorine gas to impart, to the surface of the plastic bottle, the properties same as those of the polytetrafluoroethylene, such as non-adhering property, low coefficient of friction, heat resistance and resistance against chemicals.

For effecting the chemical vapor deposition (CVD), further, a compound containing adorns, molecules or ions for constituting the thin film is obtained in a gas phase and is carried on a suitable carrier gas.

The starting compound must be highly volatile, and there are used hydrocarbons such as methane, ethane, ethylene or acetylene for forming a film of carbon or a film of a carbide. For forming a silicon film, there is used a silane, an organosilane compound or an organosiloxane compound. There are used a halide (chloride) or an organometal compound such as of titanium, zirconium, tin, aluminum, yttrium, molybdenum, tungsten, gallium, tantalum, niobium, iron, nickel, chromium or boron.

Further, there are used an oxygen gas for forming an oxide film, and a nitrogen gas or an ammonia gas for forming a nitride film.

These starting gases can be used in a suitable combination of two or more kinds depending upon the chemical composition of the thin film that is to be formed.

As the carrier gas, there can be suitably used argon, neon, helium, xenon and hydrogen.

In the present invention, it is most desired to use an organosiloxane compound such as hexamethyldisiloxane in combination with an oxygen gas from the standpoint of improving the gas barrier property of the bottle. By using the above treating gas, there is formed a silicon oxide film having excellent gas-barrier property on the inner surface of the bottle.

The amount of introducing the treating gas may vary depending upon the surface of the bottle to be treated and the kind of the gas. In treating the surface of a 2-litter plastic bottle, however, it is desired that the treating gas is fed at a flow rate of 1 to 500 cc/min. and, particularly, 2 to 200 cc/min. in the normal state per a bottle.

When the thin film is to be formed by the reaction of a plurality of starting gases, one starting gas may be fed in an excess amount. When a silicon oxide film is to be formed, for example, it is desired to feed the oxygen gas in an excess amount as compared to the silicon source gas. When a nitride is to be formed, nitrogen or ammonia may be fed in an excess amount as compared to the metal source gas.

### (Microwaves)

As the microwaves for generating a glow discharge, there can be used those microwaves of which the industrial use has been permitted having frequencies of 2.45 GHz, 5.8 GHz and 22.125 GHz.

The output of microwaves varies depending upon the surface area of the base body to be treated and the kind of the starting gas. For treating the surface of a 2-litter plastic bottle, however, it is desired that the microwaves are fed in a power of 50 to 1500 W and, particularly, 100 to 1000 W per a bottle.

### (Cooling gas and cooling gas-feeding portion 40)

In the present invention, the cooling gas may be any gas such as the air. By making the burden on the exhaust system such as vacuum pump, however, it is desired to use an inert gas such as nitrogen gas. The cooling gas may be used being cooled down to a predetermined temperature by using a heat exchanger. From the standpoint of cooling effect and cost, however, it is desired to effect the cooling by utilizing the adiabatic expansion of a compressed gas. To accomplish the efficient cooling based on the adiabatic expansion, therefore, it is desired that the cooling gas-feeding portion 40 is of a squeezed shape becoming smaller in diameter toward the plasma-treating chamber 10 and is squeezed to assume a small diameter by using, for example, an orifice. It is further desired that the ratio of compression and expansion is in a range of 5 to 200.

The cooling effect increases with an increase in the flow rate of the cooling gas. From the standpoint of a relationship to the evacuating ability of the vacuum pump for maintaining the degree of vacuum on the outer side of the plastic container to lie in a predetermined range, the flow rate of the cooling gas can be arbitrarily set which, however, is not smaller than a minimum limit (5 m³/hr) that is required. In this case, it is important that the flow rate is adjusted relying only upon the shape of the orifice unit to obtain effective adiabatic expansion.

To enhance the cooling effect, further, it is desired that the cooling gas-feeding portion 40 is provided at such a position and in such a direction that the gas introduced through the feed port is directly blown to a portion of the plastic container that is subject to be thermally deformed and cooled. In the case of the plastic container such as the bottle 28 held upside down, it is desired to form the cooling gas-feeding portion 40 in the ceiling wall 16 to positively cool the bottom portion of the bottle.

The cooling gas-feeding portions 40 are suitably provided in a required number, positions and directions for effectively cooling the portions that need be cooled depending upon the shape of the plastic containers to be treated with a chemical plasma.

An important feature of the present invention is to effect the glow discharge while cooling a portion that is subject to be thermally deformed of the plastic container that is to be treated with the plasma. The cooling makes it possible to effectively avoid the deformation and contraction of the plastic container such as the bottle.

To form a film by CVD on the inner surface of the plastic container, in particular, a microwave glow discharge is effected while blowing the cooling gas onto a portion that is subject to be thermally deformed on the outer surface of the plastic container that is to be treated with a plasma effectively preventing the plastic container such as bottle from being deformed and contracted.

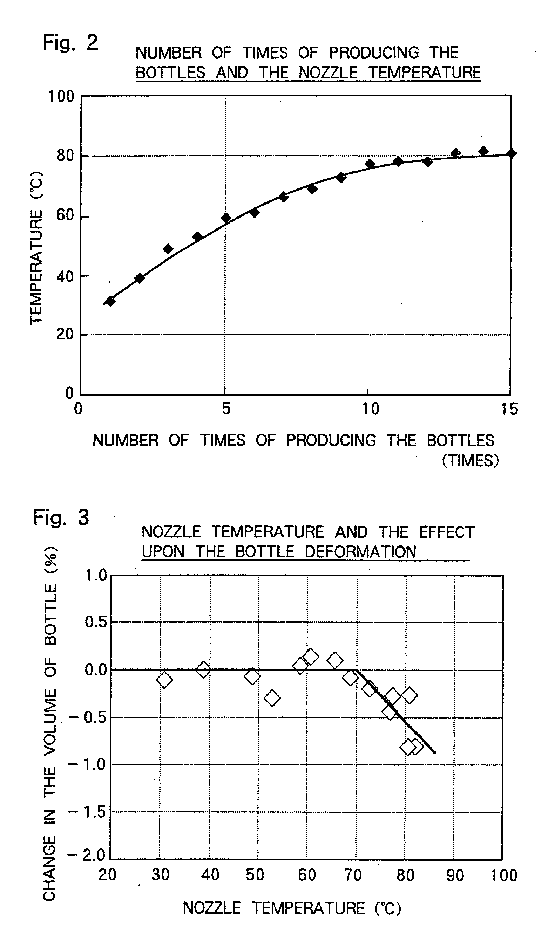

Fig. 2 is a diagram plotting a relationship between the temperature of a metallic gas-feeding pipe (nozzle temperature) and the number of times of the treatment(number of times of producing the bottles) by treating the inner surface of the bottle with the plasma relying upon the ordinary microwave glow discharge by inserting the metallic gas-feeding pipe in the plastic bottle (PET bottle) through the neck of the bottle and feeding the treating gas (mixed gas of a silicon source gas and an oxygen gas) into the bottle from the feeding pipe.

Here, the treatment with the chemical plasma was conducted under the conditions of placing a polyethylene terephthalate bottle having a volume of 500 ml in the plasma-treating chamber 10 (chamber 14), supplying, as a treating gas, an organosiloxane compound gas at a rate of 3 sccm and an oxygen gas at a rate of 30 sccm while maintaining the interior of the bottle at 20 Pa, and irradiating the microwaves of 500 W for 6 seconds while maintaining the exterior of the bottle in the plasma-treating chamber at 3000 Pa. The bottle was replaced by a new one after each completion of the treatment with the chemical plasma; i.e., the treatment with the chemical plasma was conducted repetitively at an interval of treating one bottle in every two minutes.

According to Fig. 2, it will be learned that the temperature of the gas-feeding pipe rises as the treatment with the plasma is repeated, and the temperature of the gas-feeding pipe reaches about 80°C but not higher after the repetition of the treatment with the plasma of about 10 times.

Fig. 3 is a diagram plotting a relationship between the change in the volume of the bottle when the plasma treatment is repeated in the same manner as above and the temperature of the gas-feeding pipe (nozzle temperature). Referring to Fig. 3, it will be learned that the bottle greatly deforms and contracts when the temperature of the gas-feeding pipe exceeds 70°C, i.e., if the results of Fig. 2 are also referred to, the bottle deforms and contracts greatly when the number of times of the treatment with the plasma exceeds about 8 times.

In conducting the experiment of Fig. 3, further, the bottle that has deformed and contracted was observed to find that the peripheral edge of the bottom of the bottle had been greatly deformed. This is attributed to that the residual strain is existing in large amounts in the peripheral edge of the bottom of the bottle due to the molding such as biaxial stretching and, hence, the peripheral edge of the bottom is becoming most subject to be thermally contracted.

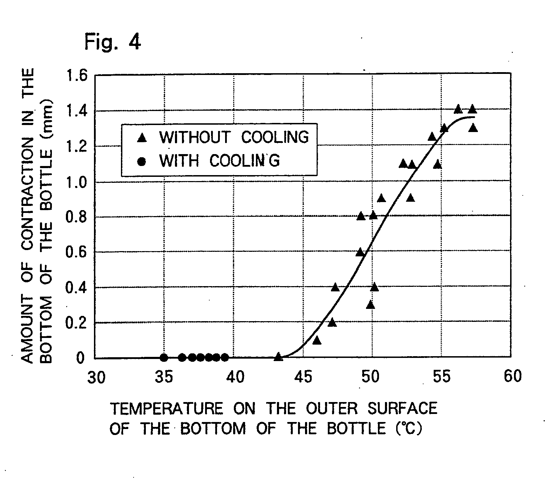

However, when the experiment is conducted under the same conditions as those of the case of Fig. 2 in accordance with the present invention but effecting the microwave glow discharge while blowing the cooling gas onto the bottom of the bottle by introducing the external air of atmospheric pressure and normal temperature at a rate of 15 m³/hr from the cooling gas-feeding portion having a hole diameter of 0.6 mm and an orifice length of 1 mm provided in the central portion of the ceiling wall 16, the temperature on the outer surface of the bottom portion of the bottle immediately after taken out from the plasma-treating chamber is obviously low and is maintained stable as compared to that of when no cooling gas is blown as shown in Fig. 4, and the bottle is effectively suppressed from being deformed and contracted.

That is, according to the present invention, the cooling gas is blown in a concentrated manner onto the bottom of the bottle that is most subject to be deformed by the thermal contraction to prevent its deformation. Therefore, the bottle as a whole is effectively suppressed from contracting, the treatment with the plasma can be repeated consecutively maintaining a short interval, and the productivity can be greatly enhanced.

In the foregoing description, the microwaves were employed as means for generating a glow discharge. So far as the film is formed by CVD relying upon the glow discharge while cooling the plastic container, however, it is also allowable to generate the glow discharge by feeding high-frequency waves instead of microwaves.

## Claims

1. A method of treating plastic containers with a chemical plasma by forming a film by CVD on the inside surface of the plastic containers in a plasma-treating chamber, wherein said plastic container is cooled at the time of forming the film by CVD on the plastic container by generating a glow discharge by feeding a gas for plasma treatment into the plasma-treating chamber, the gas for plasma treatment is fed into the plastic container to generate the glow discharge on the inner surface of the plastic container in a state of a reduced pressure, the cooling gas is blown to the outer surface of the plastic container while maintaining the exterior of the plastic container in a state of a reduced pressure where no glow discharge takes place, and the plastic container is held upside down in the plasma-treating chamber and, in this state, the glow discharge is generated and the cooling gas is blown to the outer surface of the container.

2. A method of treatment with a chemical plasma according to claim 1, wherein compressed air or nitrogen is used as said cooling gas.

3. A method of treatment with a chemical plasma according to claim 1, wherein said glow discharge is generated by feeding microwaves or high-frequency waves.

4. An apparatus for treating plastic containers with a chemical plasma by forming a film by CVD on the inside surface of the plastic container in a plasma-treating chamber, comprising means for holding the container upside down in the plasma-treating chamber, a gas-feeding pipe for feeding a gas for plasma treatment into the plastic container through a first exhaust portion, a microwave or high frequency wave feeding portion for generating a glow discharge in the plastic container in the plasma-treating chamber, a second exhaust portion for maintaining the exterior of the plastic container in a state of a reduced pressure where no glow discharge takes place, and a cooling gas-feeding portion for blowing a cooling gas onto the outer surface of the plastic container, so that the film is formed by CVD on the inner surface of the plastic container.

5. An apparatus for treating plastic containers with a plasma according to claim 4, wherein said cooling gas-feeding portion is provided in the ceiling wall and/or in the cylindrical side wall of the plasma-treating chamber.

6. An apparatus for treating plastic containers with a plasma according to claim 4, wherein said cooling gas-feeding portion is of a squeezed shape having a diameter becoming smaller toward the inside of the plasma-treating chamber.

## Patentansprüche

1. Verfahren des Behandelns von Kunststoffbehältern mit einem chemischen Plasma durch Bilden eines Films mittels CVD auf der inneren Oberfläche der Kunststoffbehälter in einer Plasmabehandlungskammer, wobei der genannte Kunststoffbehälter zum Zeitpunkt des Bildens des Films mittels CVD auf dem Kunststoffbehälter durch Erzeugen einer Glimmentladung durch Zuführen eines Gases für die Plasmabehandlung in die Plasmabehandlungskammer gekühlt wird, das Gas für die Plasmabehandlung in den Kunststoffbehälter zugeführt wird, um die Glimmentladung auf der inneren Oberfläche des Kunststoffbehälters in einem Zustand eines reduzierten Drucks zu erzeugen, das Kühlgas an die äußere Oberfläche des Kunststoffbehälters geblasen wird, während das Äußere des Kunststoffbehälters in einem Zustand eines reduzierten Drucks gehalten wird wo keine Glimmentladung stattfindet und der Kunststoffbehälter verkehrt herum in der Plasmabehandlungskammer gehalten wird und in diesem Zustand die Glimmentladung erzeugt wird und das Kühlgas zur äußeren Oberfläche des Behälters geblasen wird.

2. Verfahren der Behandlung mit einem chemischen Plasma nach Anspruch 1, wobei Druckluft oder Stickstoff als das genannte Kühlgas verwendet wird.

3. Verfahren der Behandlung mit einem chemischen Plasma nach Anspruch 1, wobei die genannte Glimmentladung durch Zuführen von Mikrowellen oder Hochfrequenzwellen erzeugt wird.

4. Vorrichtung zum Behandeln von Kunststoffbehältern mit einem chemischen Plasma durch Bilden eines Films mittels CVD auf der inneren Oberfläche des Kunststoffbehälters in einer Plasmabehandlungskammer, umfassend Mittel zum Halten des Behälters verkehrt herum in der Plasmabehandlungskammer, eine Gaszufuhrleitung zum Zuführen eines Gases für die Plasmabehandlung in den Kunststoffbehälter durch einen ersten Auslassabschnitt, einen Mikrowellen- oder Hochfrequenzwellen-Zufuhrabschnitt zum Erzeugen einer Glimmentladung im Kunststoffbehälter in der Plasmabehandlungskammer, einen zweiten Auslassabschnitt zum Halten des Äußeren des Kunststoffbehälters in einem Zustand eines reduzierten Drucks wo keine Glimmentladung stattfindet und einen Kühlgas-Zufuhrabschnitt zum Blasen eines Kühlgases auf die äußere Oberfläche des Kunststoffbehälters, so dass der Film mittels CVD auf der inneren Oberfläche des Kunststoffbehälters gebildet wird.

5. Vorrichtung zum Behandeln von Kunststoffbehältern mit einem Plasma nach Anspruch 4, wobei der genannte Kühlgaszufuhrabschnitt in der Deckenwand und/oder in der zylindrischen Seitenwand der Plasmabehandlungskammer vorgesehen ist.

6. Vorrichtung zum Behandeln von Kunststoffbehältern mit einem Plasma nach Anspruch 4, wobei der genannte Kühlgaszufuhrabschnitt eine gequetschte Form mit einem zum Inneren der Plasmabehandlungskammer hin kleiner werdenden Durchmesser hat.

## Revendications

1. Procédé de traitement de récipients en plastique au plasma chimique par la formation d'un film par DCPV sur la surface interne des récipients en plastique dans une chambre de traitement au plasma, dans lequel ledit récipient en plastique est refroidi au moment de la formation du film par DCPV sur le récipient en plastique par la génération d'une décharge luminescente par l'alimentation d'un gaz de traitement au plasma dans la chambre de traitement au plasma, le gaz de traitement au plasma est alimenté dans le récipient en plastique pour générer la décharge luminescente sur la surface intérieure du récipient en plastique dans un état de pression réduite, le gaz de refroidissement est soufflé sur la surface extérieure du récipient en plastique alors que l'extérieur du récipient en plastique est maintenu dans un état de pression réduite dans lequel aucune décharge luminescente ne se produit, et le récipient en plastique est tenu à l'envers dans la chambre de traitement au plasma et, dans cet état, la décharge luminescente est générée et le gaz de refroidissement est soufflé sur la surface extérieure du récipient.

2. Procédé de traitement au plasma chimique selon la revendication 1, dans lequel on utilise de l'air comprimé ou de l'azote comprimé pour ledit gaz de refroidissement.

3. Procédé de traitement au plasma chimique selon la revendication 1, dans lequel ladite décharge luminescente est générée par l'alimentation de micro-ondes ou d'ondes de haute fréquence.

4. Appareil permettant de traiter des récipients en plastique au plasma chimique par la formation d'un film par DCPV sur la surface interne du récipient en plastique dans une chambre de traitement au plasma, comportant un moyen destiné à tenir le récipient à l'envers dans la chambre de traitement au plasma, un tuyau d'alimentation en gaz destiné à alimenter un gaz de traitement au plasma dans le récipient en plastique au travers d'une première partie d'évacuation, une partie d'alimentation en micro-ondes ou ondes de haute fréquence destinée à générer une décharge luminescente dans le récipient en plastique dans la chambre de traitement au plasma, une deuxième partie d'évacuation destinée à maintenir l'extérieur du récipient en plastique dans un état de pression réduite dans lequel aucune décharge luminescente ne se produit, et une partie d'alimentation en gaz de refroidissement destinée à souffler un gaz de refroidissement sur la surface extérieure du récipient en plastique, de sorte que le film est formé par DCPV sur la surface intérieure du récipient en plastique.

5. Appareil permettant de traiter des récipients en plastique au plasma selon la revendication 4, dans lequel ladite partie d'alimentation en gaz de refroidissement est mise en oeuvre dans la paroi plafond et/ou dans la paroi latérale cylindrique de la chambre de traitement au plasma.

6. Appareil permettant de traiter des récipients en plastique au plasma selon la revendication 4, dans lequel ladite partie d'alimentation en gaz de refroidissement est d'une forme comprimée ayant un diamètre rétrécissant vers l'intérieur de la chambre de traitement au plasma.
